Europäisches Patentamt

European Patent Office

Office européen des brevets

(19)

(11) **EP 0 465 515 B1**

(12) **EUROPÄISCHE PATENTSCHRIFT**

(45) Veröffentlichungstag und Bekanntmachung des Hinweises auf die Patenterteilung:
**14.08.1996 Patentblatt 1996/33**

(21) Anmeldenummer: **90905183.1**

(22) Anmeldetag: **31.03.1990**

(51) Int Cl.6: **H01J 37/32**, H01J 37/304, G01N 21/62, H01J 37/305

(86) Internationale Anmeldenummer:
**PCT/DE90/00255**

(87) Internationale Veröffentlichungsnummer:
**WO 90/12415 (18.10.1990 Gazette 1990/24)**

(54) **VERFAHREN ZUR ÜBERWACHUNG VON IONEN-UNTERSTÜTZTEN BEARBEITUNGSVORGÄNGEN AN WAFERN UND VORRICHTUNG ZUR DURCHFÜHRUNG DES VERFAHRENS**

PROCESS AND DEVICE FOR MONITORING ION ASSISTED MACHINING PROCESSES ON WAFERS

PROCEDE ET DISPOSITIF POUR CONTROLER DES PROCESSUS D'USINAGE ASSISTES PAR VOIE IONIQUE SUR DES TRANCHES

(84) Benannte Vertragsstaaten:
**AT BE CH DE FR GB IT LI LU NL SE**

(30) Priorität: **31.03.1989 DE 3910491**

(43) Veröffentlichungstag der Anmeldung:
**15.01.1992 Patentblatt 1992/03**

(73) Patentinhaber: **FRAUNHOFER-GESELLSCHAFT ZUR FÖRDERUNG DER ANGEWANDTEN FORSCHUNG E.V. 80636 München (DE)**

(72) Erfinder: **HEINRICH, Friedhelm D-1000 Berlin 41 (DE)**

(74) Vertreter: **Münich, Wilhelm, Dr. et al Kanzlei Münich, Steinmann, Schiller Wilhelm-Mayr-Str. 11 80689 München (DE)**

(56) Entgegenhaltungen:
- **APPLIED PHYSICS LETTERS. vol, 55, no. 14, 02 Oktober 1989, NEW YORK US, Seiten 1474-1476; Heinrich et al.: "New and simple optical method for in-situ etch rate determination and endpoint detection"**
- **REVIEW OF SCIENTIFIC INSTRUMENTS, vol. 51, no. 11, November 1980, NEW YORK US, Seiten 1451-1462; Burrell et al.: "Doppler shift spectroscopy of powerful neutral beams"**
- **JOURNAL OF APPLIED PHYSICS, vol. 53, no. 6, Juni 1982, NEW YORK US, Seiten 4389-4394; Dzioba et al.: "Optical spectroscopy during reactive ion beam etching of Si and Al targets"**
- **JOURNAL OF VACUUM SCIENCE AND TECHNOLOGY: PART B. vol. 3, no. 5, September 1985, NEW YORK US, Seiten 1543-1545; Husinsky et al.: "Doppler shift laser fluorescence spectroscopy of sputtered and evaporated atoms under Ar+ bombardment"**

## Beschreibung

## Technisches Gebiet

Die Erfindung bezieht sich auf ein Verfahren zur Überwachung von Ionen-unterstützten Bearbeitungsvorgängen an Wafern in einer Prozeßkammer sowie auf eine Vorrichtung zur Durchführung dieses Verfahrens.

## Stand der Technik

Ionen-unterstützte Bearbeitungsvorgänge werden sowohl zum Abtragen von Material als auch zum Auftragen von Material bzw. Beschichten von Halbleiter-, Metall-, Glas- oder Kunststoffsubstraten verwendet. Die vorstehend genannten Materialien werden im folgenden unter dem Begriff "Wafer" zusammengefaßt.

Bearbeitungsvorgänge, bei denen Material abgetragen wird, können beispielsweise reaktives Ionenätzen (reactive Ion etching "RIE"), magnetisch verstärktes reaktives Ionenätzen (magnetically enhanced RIE "MERIE"), Triodenätzen, reaktives Ionenstrahlätzen (reactive Ion beam etching "RIBE"), chemisch unterstütztes reaktives Ionenstrahlätzen (chemically assisted Ion beam etching "CAIBE"), Ionenfräsen (Ion milling) oder Sputtern sein.

Bei sämtlichen Ionen-unterstützten Bearbeitungsvorgängen ist es für die Bearbeitungsführung wesentlich, die Energie der Ionen und die Divergenz des Ionenstrahls zu kennen. Ferner ist es in einer Reihe von Fällen von Bedeutung, eine eventuelle Aufladung des Wafers zu erfassen, da gerade bei dünnen isolierenden Schichten schon eine geringe Aufladung zu Spannungsdurchbrüchen führen kann. Weiterhin ist es beispielsweise beim RIE erforderlich, "in-situ" die Ätzrate zu bestimmen bzw. eine "Endpunkt-Kontrolle" für den Bearbeitungsvorgang zu haben.

Die Ermittlung der vorstehend genannten Größen bzw. Bearbeitungsparameter ist gemäß dem Stand der Technik nur mit einer Reihe von unterschiedlichen Meßverfahren möglich, die gegebenenfalls in einer Prozeßkammer gleichzeitig verwendet werden müssen. So wird gegenwärtig die Divergenz des Ionenstrahls in der Regel mit "leitenden Bechern" gemessen (Strommessung). Die Anordnung der hierzu erforderlichen Meßvorrichtungen in einer Prozeßkammer "stört" aber den Ionenstrahl und damit den Bearbeitungs-vorgang. Die Schichtdicke dagegen wird in der Regel interferometrisch gemessen, so daß die Prozeßkammer so ausgelegt werden muß, daß der Einsatz beispielsweise eines Laserinterferometers möglich wird, vgl. z. B. die PCT-Anmeldung WO 88/07261. In dieser Druckschrift ist auch die Verwendung eines optischen Spektrometers zur chemischen Identifizierung der Reaktionsprodukte von der Oberfläche des Wafers beschrieben.

Aus dem Artikel "Doppler shift spectroscopy of powerful neutral beams" von Burrell et al., erschienen in Review of Scientific Instruments, Vol. 51, (1980), Nov., No. 11, N.Y. USA, ist zu entnehmen, daß aus der spektralen Breite der dopplerverschobenen Emissionslinien die Strahldivergenz ermittelt werden kann. Es werden jedoch in diesem Artikel ausschließlich Untersuchungen an neutralen Atomstrahlen angestellt.

## Beschreibung der Erfindung

Der Erfindung liegt die Aufgabe zugrunde, ein Verfahren zur Überwachung von Ionen-unterstützten Bearbeitungsvorgängen an Wafern in einer Prozeßkammer anzugeben, mit dem die für die Bearbeitungsführung wesentlichen Größen bzw. Bearbeitungsparameter mit möglichst geringem Aufwand praktisch gleichzeitig ermittelt werden können.

Erfindungsgemäße Lösungen dieser Aufgabe sind in den Ansprüchen 1, 2 bzw. 3 gekennzeichnet. Weiterbildungen der Erfindung sind in den Unteransprüchen angegeben.

Erfindungsgemäß wird ein Verfahren zur Überwachung von Ionen-unterstützten Bearbeitungsvorgängen an Wafern in einer Prozeßkammer derart angegeben, daß zur Bestimmung der Energie der Ionen des Ionenstrahls die Rot-Verschiebung und/oder die sich durch Reflexion von Ionen und/ oder Neutralteilchen an der Wafer-Oberfläche ergebende Blau-Verschiebung von Emissionslinien von in der Prozeßkammer vorhandenen Gasen bestimmt wird.

Bei dem erfindungsgemäßen Verfahren ist erkannt worden, daß die für Ionen-unterstützten Bearbeitungsvorgänge an Wafern wichtigen Größen bzw. Prozeßparameter mittels Emissionsspektrographie von in der Prozeßkammer vorhandenen Arbeitsgasen ermittelt werden können. Dabei werden unter Arbeitsgase sämtliche in der Prozeßkammer vorhandenen Gase, also beispielsweise die von der Ionenquelle gelieferten Ionen (bzw. schnelle Neutralteilchen), das in der Kammer vorhandene Hintergrundgas (typischer Druck in der Arbeitskammer $\approx 10^{-6} - 10^{-7}$ mbar), zusätzliches in der Prozeßkammer vorhandenes Arbeitsgas, wie dies beim CAIBE-Verfahren oder Beschichten der Fall ist, oder Reaktionsprodukte von der Oberfläche verstanden.

Auf dem Weg zwischen Ionenquelle und Wafer-Oberfläche stößt ein Teil der Ionen mit Neutralteilchen in der Prozeßkammer zusammen. Diese Stoßprozesse führen mit einer gewissen Wahrscheinlichkeit zu einer elektronischen Anregung der Stoßpartner. Das beim "Löschen" der elektronischen Anregung erzeugte Licht ist aufgrund der Geschwindigkeit der Stoßpartner im Vergleich zu thermischen Teilchen zu längeren Wellenlängen hin "Doppler-verschoben", also Rot-verschoben.

Aus dem Abstand des z.B. Rot-verschobenen Maximums und des nicht-verschobenen Maximums, das bei thermischen Teilchen auftritt, läßt sich deshalb die Geschwindigkeit und damit die Energie der Teilchen berechnen (Anspruch 4).

Weiterhin werden mit einer gewissen Wahrscheinlichkeit an der Wafer-Oberfläche reflektierte Teilchen elektronisch durch den Stoß mit dem Wafer angeregt. Bei diesen Teilchen tritt eine Blau-Verschiebung der Emissionslinien auf.

Auch aus dem Abstand des Blau-verschobenen Maximums von nicht-verschobenen Maximum läßt sich ebenfalls die Teilchen-Energie bestimmen (Anspruch 4).

Ferner läßt die spektrale Breite der Verteilung der Emissionen um das Rot-verschobene oder das Blau-verschobene Maximum Rückschlüsse auf die Strahldivergenz zu (Anspruch 5).

Weiterhin entsteht durch die Aufladung des Wafers eine Gegenspannung, die die Ionen abbremst, so daß die spektrale Rot- und die Blauverschiebung vermindert wird. Deshalb wird erfindungsgemäß nach Anspruch 2 zur Erfassung einer eventuellen Aufladung des Wafers die spektrale Lage des Rot-und/oder Blau-verschobenen Maximums bzw. die zeitliche Änderung der spektralen Lage erfaßt.

Dies ermöglicht u.a. erstmals eine zuverlässige DC-Bias-Messung. d.h. ein Bestimmung der Potentialdifferenz zwischen Plasma und Wafer bei RIE-Bearbeitungsvorgängen. Bei kathodischer Extraktion (DC,HF oder NF) über eine Plasmarandschicht, wie dies beim RIE-Verfahren und bei RI-Depositionsverfahren der Fall ist, ist nicht nur über die Teilchenenergie die Bestimmung der sich selbsttätig einstellenden Potentialdifferenz, sondern insbesondere bei niedrigem Druck auch die Ermittlung der Energieverteilung der Teilchen möglich.

Ein Teil des emittierten Lichts gelangt direkt in die Nachweisvorrichtung, während der andere Teil des in die Nachweisvorrichtung gelangten Lichts zunächst an der Wafer-Oberfläche reflektiert worden ist.

Handelt es sich bei dem Wafer um ein beschichtetes Wafer, beispielsweise um ein Si-Wafer mit einer darauf aufgebrachten $SiO_2$-Schicht, so kommt es zu Interferenzen des an der oberen und an der unteren Grenzfläche reflektierten Lichts. Damit ist die Intensität des empfangenen Lichts schichtdickenabhängig.

Erfindungsgemäß wird deshalb gemäß Anspruch 3 zur Erfassung der momentanen Dicke der bearbeiteten Schicht die zeitliche Änderung der Intensität der Blau-verschobenen oder der unverschobenen Spektrallinien und/oder die spektrale Lage des Blau-verschobenen Maximums erfaßt.

Sowohl die Größe der Rot- als auch der Blau-Verschiebung der Emissionslinien von in der Prozeßkammer vorhandenen Arbeitsgasen kann beispielsweise mit einem Monochromator mit einer nachgeschalteten Photomultiplier-Röhre oder mit anderen Nachweisvorrichtungen, wie Interferenzfiltern gemessen werden. In jedem Falle ist es bevorzugt, wenn die Nachweisvorrichtung die verschiedenen Emissionen kollinear, d.h. in der Achse des Ionenstrahls erfaßt (Anspruch 6). Dies hat sowohl den Vorteil, daß dann die Größe der gemessenen Verschiebung bei gegebener Teilchengeschwindigkeit am größten ist, als auch den Vorteil, daß die Schichtdickenbestimmung vereinfacht wird.

## Kurze Beschreibung der Zeichnung

Die Erfindung wird nachstehend anhand von Ausführungsbeispielen unter Bezugnahme auf die Zeichnung beschrieben. Es zeigen:

Fig. 1 den prinzipiellen Aufbau einer Vorrichtung zur Durchführung des erfindungsgemäßen Verfahrens,

Fig. 2 bis 5 Meßergebnisse mit der in Fig. 1 dargestellten Vorrichtung.

## Beschreibung von Ausführungsbeispielen

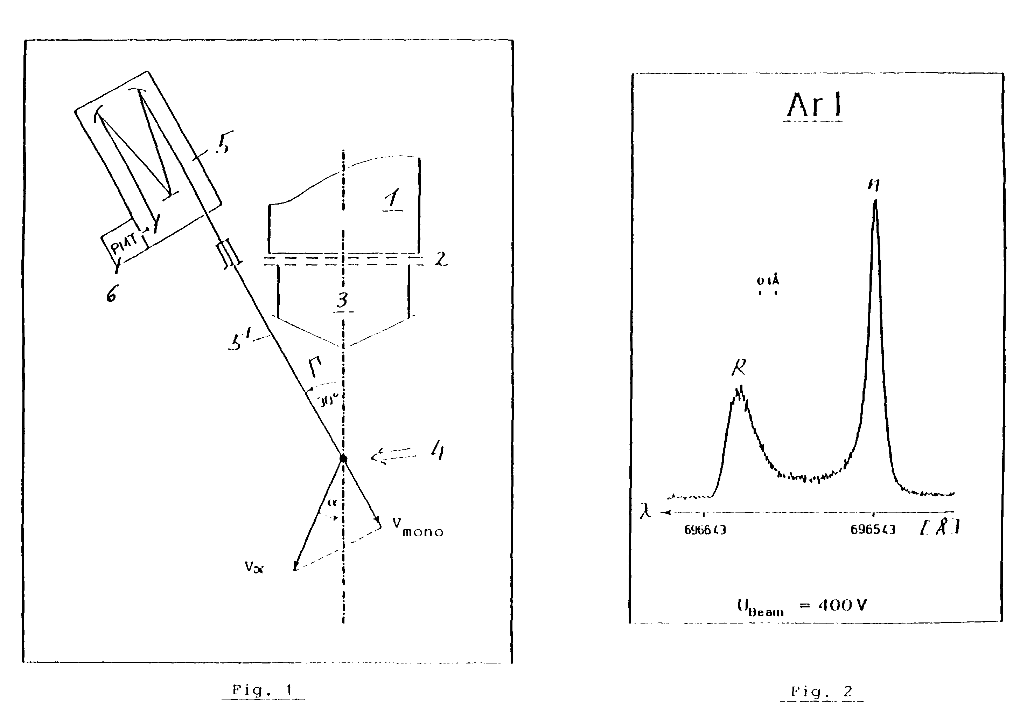

Die in Fig. 1 dargestellte Vorrichtung weist eine Ionenquelle 1 auf, die Ionen als Plasma liefert, aus dem eine Reihe von Gittern 2 einen Ionenstrahl 3 auf ein nicht dargestelltes Wafer beschleunigt. Bei dem gezeigten Ausführungsbeispiel wird eine Zweigitteroptik verwendet. Ausdrücklich soll darauf hingewiesen werden, daß die Ausbildung der Ionenquelle für das erfindungsgemäße Verfahren nicht entscheidend ist, und daß das erfindungsgemäße Verfahren beispielsweise auch dann anwendbar ist, wenn - wie beispielsweise beim RIE-Verfahren - Ionen aus einem Plasma heraus über ein sich selbsttätig einstellendes Potential auf Wände etc. beschleunigt werden, so daß im eigentlichen Sinne nicht vom einem Ionenstrahl gesprochen werden kann.

Die Ionen des Ionenstrahls stoßen entsprechend dem Gas-Hintergrunddruck in der Prozeßkammer (ca $10^{-7}$ -$10^{-6}$ mbar) mit anderen Teilchen zusammen. Dies ist in Fig. 1 durch das Bezugszeichen 4 symbolisiert. Dabei werden i.f. unter Gas bzw. Arbeitsgas sämtliche in der Prozeßkammer vorhandenen Gase, also beispielsweise die von der Ionenquelle gelieferten Ionen (bzw. rekombinierte Neutralteilchen), das in der Kammer vorhandene Hintergrundgas, zusätzliches in der Prozeßkammer vorhandenes Arbeitsgas, wie die beim CAIBE-Verfahren der Fall ist, oder Reaktionsprodukte von der Oberfläche verstanden.

Diese Stoßprozesse führen mit einer gewissen Wahrscheinlichkeit zu einer elektronischen Anregung der Stoßpartner. Das beim "Löschen" der elektronischen Anregung erzeugte Licht wird bei dem in Fig. 1 dargestellten Ausführungsbeispiel mit einem Monochromator 5, der einen Photomultiplier 6 aufweist, nachgewiesen. Die Achse 5' des Monochromators 5 ist bei dem gezeigten Ausführungsbeispiel unter einem Winkel $\Gamma = 30°$ zur Achse des Ionenstrahls 3 angeordnet. Nach dem Stoß schließt die Bewegungsrichtung der "stoßenden Ions" mit der Achse des Ionenstrahls den Winkel $\alpha$ ein. $v_\alpha$ ist die Geschwindigkeit des Ions nach dem Stoß.

Im folgenden sollen anhand der Fig. 2 bis 5 Meßergebnisse mit der in Fig. 1 dargestellten Vorrichtung erläutert werden. Dabei sind im folgenden lediglich Messungen im Bereich der unverschobenen (neutralen) Argon-Linie $\lambda_o$ = 696,543 nm (6965,43 Å) dargestellt. Selbstverständlich können je nach Anwendungsfall nahezu beliebige Emissionslinien der verwendeten Ionen und/oder von in der Prozeßkammer vorhandenen Teilchen ausgewertet werden.

Fig. 2 zeigt ein typische Messung im Bereich der Ar I-Linie, wenn in der Prozeßkammer kein Substrat vorhanden ist. Zusätzlich zu der "scharfen" unverschobenen Emissionslinie n, die von thermischen Teilchen herrührt, beobachtet man ein kleineres "Rot-verschobenes" Maximum R, das von schnellen Teilchen herrührt.

Dabei ist die Wellenlängenverschiebung $\Delta\lambda$, d.h. der spektrale Abstand des unverschobenen Maximums n und des Rot-verschobenen Maximums R, durch die Projektion der Teilchengeschindigkeit $v_\alpha$ auf die Monochromatorachse 5' gegeben:

$$\Delta\lambda = \lambda_o * v_\alpha * \cos(\Gamma \pm \alpha)$$

($\lambda_o$ ist die Wellenlänge der unverschobenen Emissionslinie).

Da der Ablenkwinkel $\alpha$ u.a. eine Funktion der Strahldivergenz ist, lassen sich aus dem Abstand des Rot-verschobenen Peak-Maximums von unverschobenen Maximum die Teilchengeschwindigkeit und damit die Energie des Ionenstrahls bestimmen und aus der Breite des Rot-verschobenen Maximums zumindest qualitative Rückschlüsse auf die Divergenz des Ionenstrahls ziehen.

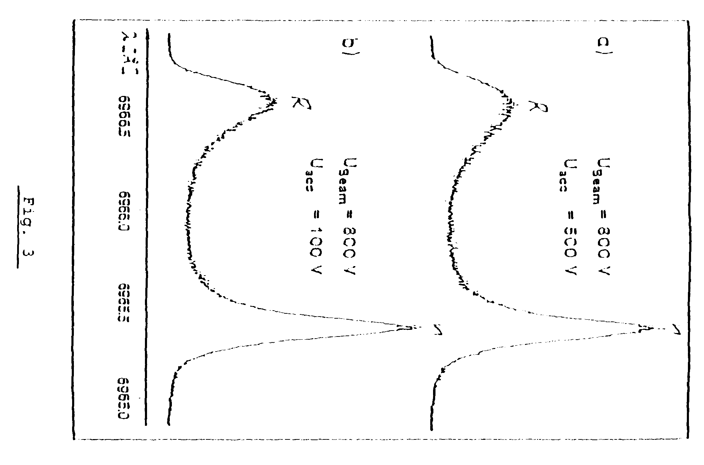

Fig. 3 zeigt den Einfluß unterschiedlicher Strahldivergenzen auf die "Form" des Rot-verschobenen Maximums. Dabei sind in Teilfigur (a) das Meßergebnis bei einem Strahl mit einer vergleichsweise großen Divergenz und in Teilfigur (b) das Ergebnis bei einem Strahl mit kleinerer Divergenz dargestellt. Die Strahldaten sind jeweils den Teilfiguren zu entnehmen. $U_{Beam}$ bezeichnet die Beschleunigungsspannung und $U_{acc}$ die am zweiten Gitter der Zwei-Gitter-Optik anliegende Spannung (bezogen auf 0 V).

Fig. 4 zeigt das Ergebnis, das man erhält, wenn im Ionenstrahl 3 ein Wafer angeordnet ist. Durch Reflexion an der Waferoberfläche tritt auch ein zu kürzeren Wellenlängen (Blau-verschobenes) Maximum B auf, aus dessen Abstand vom unverschobenen Maximum sich wiederum die Teilchenenergie bestimmen und aus dessen Breite sich Informationen über die Strahldivergenz gewinnen lassen.

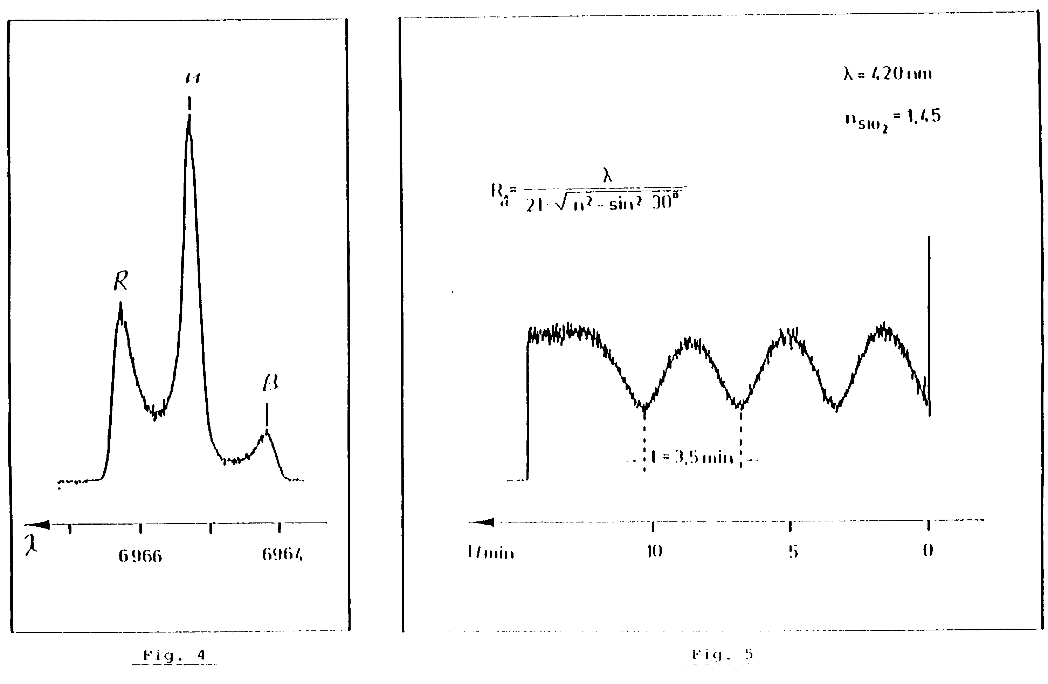

Fig. 5 zeigt die zeitliche Variation der Intensität des "Blau-verschobenen" Maximums bei einem beschichteten Wafer. Aufgrund der kurzen Lebensdauer (ca. 10-100 ns) der elektronisch angeregten Zustände erfaßt man im Emissionsspektrum nur Teilchen, die sich in einem Bereich mit einer Dicke von einigen Millimetern über der Wafer-Oberfläche befinden. Ein Teil des emittierten Lichts gelangt direkt in die Nachweisvorrichtung, während der andere Teil des in die Nachweisvorrichtung gelangten Lichts zunächst an der Wafer-Oberfläche reflektiert worden ist.

Handelt es sich bei dem Wafer um ein beschichtetes Wafer, beispielsweise um ein Si-Wafer mit einer darauf aufgebrachten $SiO_2$-Schicht, so kommt es zu Interferenzen des an der oberen und an der unteren Grenzfläche reflektierten Lichts. Damit ist die Intensität des empfangenen Lichts schichtdickenabhängig.

Bei dem in Fig. 5 exemplarisch dargestellten Bearbeitungsvorgang "Sputtern" ergibt sich ein rein sinusförmiges Interferenzsignal, aus dessen "Periode" sich die Ätzrate $R_ä$ nach folgender Formel bestimmen läßt:

$$R_ä = \lambda /2 * t * \sqrt{(n^2 - \sin^2\Gamma)}$$

hierbei ist t der zeitliche Abstand zweier Maxima (Minima) und n der Brechungsindex der oberen Schicht.

Ist bei dem dargestellten Beispiel die Oxidschicht abgetragen, so ändert sich das Signal nicht mehr, so daß man eine zuverlässige Endpunkt-Kontrolle erhält.

Bei dem gezeigten Ausführungsbeispiel schließen die Achse 5' des Monochromators 5 und die Achse des Ionenstrahls 3 einen Winkel $\Gamma <> 0°$ ein. In vielen Anwendungsfällen ist es jedoch bevorzugt, wenn der Winkel $\Gamma = 0°$ ist, da dann die Schichtdickenbestimmung erleichtert wird und die Verschiebung der Maxima bei gegebener Teilchengeschwindigkeit am größten ist. Dies kann durch die Verwendung einer "durchsichtigen" Quelle 1 realisiert werden, "hinter" der die Nachweiseinrichtung für das emittierte Licht angeordnet ist. Von besonderem Vorteil bei der Verwendung der verschobenen Linien ist nämlich, daß es auf diese Weise möglich ist, durch die Ionenquelle und die Extraktionsoptik "hindurchzusehen".

Weiterhin ist es zur Bestimmung der Ätzrate auch möglich, die nicht verschobene Emissionslinie auszuwerten. Für die Auswertung ist eine spektrale Trennung der Linien nicht erforderlich. Als Nachweisvorrichtung können auch andere Vorrichtungen, wie Interferenzfilter mit nachgeschalteten Photomultipliern oder anderen Lichtempfängern verwendet werden.

In jedem Falle hat das erfindungsgemäße Verfahren jedoch den Vorteil, daß ohne zusätzliche Lichtquelle nahezu gleichzeitig die Bestimmung der Ionenenergie, der Strahldivergenz, der Schichtdicke und des Bearbeitungsendpunktes sowie der Aufladung des Wafers möglich ist.

## Gewerbliche Anwendbarkeit

Die Erfindung kann zur Überwachung sämtlicher Ionen-unterstützter Bearbeitungsvorgänge und insbesondere beim Abtragen von Material sowie beim Auftragen von Material bzw. Beschichten von Halbleiter-, Metall-, Glas- oder Kunststoffsubstraten verwendet werden.

## Patentansprüche

1. Verfahren zur Überwachung von Ionen-unterstützten Bearbeitungsvorgängen an Wafern in einer Prozeßkammer,
dadurch **gekennzeichnet**, daß zur Bestimmung der Energie der Ionen des Ionenstrahls die Rot-Verschiebung und/oder die sich durch Reflexion von Ionen und/ oder Neutralteilchen an der Wafer-Oberfläche ergebende Blau-Verschiebung von Emissionslinien von in der Prozeßkammer vorhandenen Gasen bestimmt wird.

2. Verfahren nach Anspruch 1 oder nach dem Oberbegriff des Anspruchs 1,
dadurch **gekennzeichnet**, daß zur Erfassung einer eventuellen Aufladung des Wafers die spektrale Lage des Rot-und/ oder Blau-verschobenen Maximums bzw. die zeitliche Änderung der spektralen Lage erfaßt.

3. Verfahren nach Anspruch 1, 2 oder nach dem Oberbegriff des Anspruchs 1,
dadurch **gekennzeichnet**, daß zur Erfassung der momentanen Dicke einer bearbeiteten Oberflächenschicht des Wafers die zeitliche Änderung der Intensität der Blau-verschobenen oder der unverschobenen Spektrallinien und/oder die spektrale Lage des Blau-verschobenen Maximums erfaßt wird.

4. Verfahren nach Anspruch 1,
dadurch **gekennzeichnet**, daß die Energie der Teilchen des Strahls aus dem Abstand des oder der verschobenen Maxima und des nicht verschobenen Maximums bestimmt wird.

5. Verfahren nach Anspruch 1 oder 4,
dadurch **gekennzeichnet**, daß die Divergenz des Strahls aus der Breite des Rot-verschobenen und/ oder des Blau-verschobenen Maximums bestimmt wird.

6. Vorrichtung zur Durchführung des Verfahrens nach einem der Ansprüche 1 bis 5,
dadurch **gekennzeichnet**, daß die Nachweisvorrichtung die Emissionen durch die Ionenquelle hindurch erfaßt.

## Claims

1. Method of monitoring ion-assisted machining processes on wafers ina process chamber,
**characterized** in that for a determination of the ion energy of the ion beam the red shift of the emission lines of gases, and/or their blue shift, is determined, which results from the reflexion of ions and/or neutral particles at the surface of said wafer, which gases are present in said process chamber,

2. Method according to Claim 1,
**characterized** in that the spectral position of the red-shifted and/or blue-shifted maximum or the variation versus time of the spectral position, respectively, is determined so as to detect a possible charging of the wafer.

3. Method according to Claim 1, 2 or the characterizing clause of Claim 1,
**characterized** in that the variation of the intensity versus time of the blue-shifted or non-shifted spectral lines, and/or the spectral position of the blue-shifted maximum is determined so as to detect the instantaneous thickness of a machined surface layer of said wafer.

4. Method according to Claim 1,
**characterized** in that the energy of the beam particles is determined by deriving it from the spacing between the shifted maximum(s) and the non-shifted maximum.

5. Method according to Claim 1 or 4,
**characterized** in that the beam divergence is determined by deriving it fro the width of the red-shifted maximum and/or the blue-shifted maximum.

6. Device for carrying out the method according to any of Claims 1 to 5,
**characterized** in that said detector device detects the emissions through said ion source.

## Revendications

1. Procédé à surveiller des opérations d'usinage assistés par voie ionique sur des galettes, dans une chambre d'opérations,
**caractérisé** en ce qu'en vue d'une détermination de l'énergie des ions du faisceau ionique on détecte le déplacement des raies d'émission des gaz vers le rouge, et/ ou leur déplacement vers le bleu, qui résulte de la réflexion des ions et/ou des particules neutres à la surface de ladite galette, lesquels gaz sont présents dans ladite chambre d'opérations.

2. Procédé selon la revendication 1,
**caractérisé** en ce que la position spectrale du maximum déplacé vers le rouge et/ ou le bleu, ou respectivement la variation de la position spectrale dans le temps, est détecté pour une détection d'une charge éventuelle de la galette.

3. Procédé selon la Revendication 1, 2 ou le préambule de la revendication 1,
**caractérisé** en ce que la variation de l'intensité dans le temps des raies spectrales déplacées vers le bleu ou non déplacées, et/ou la position spectrale du maximum déplacé vers le bleu est détectée pour une détection de l'épaisseur instantanée d'une couche superficielle usinée de ladite galette.

4. Procédé selon la revendication 1,
   **caractérisé** en ce que l'énergie des particules du faisceau est déterminée en la dérivant de l'écart entre le(s) maximum(s) déplacé(s) et le maximum non déplacé.

5. Procédé selon la revendication 1 ou 4,
   **caractérisé** en ce que la divergence du faisceau est déterminée en la dérivant de la largeur du maximum déplacé vers le rouge et/ou du maximum déplacé vers le bleu.

6. Dispositif à réaliser le procédé selon une quelconque des revendications 1 à 5,
   **caractérisé** en ce que ledit dispositif détecteur détecte les émissions à travers ladite source d'ions.

Ar I

U$_{Beam}$ = 400 V

_Fig. 2_

V$_{mono}$

30°

V$_\alpha$

PMT

_Fig. 1_

Fig. 3

EP 0 465 515 B1

$$R_a = \frac{\lambda}{2t \cdot \sqrt{n^2 - \sin^2 30°}}$$

$\lambda = 420\ nm$

$n_{SiO_2} = 1.45$

t = 3,5 min

λ    6966    6964

t/min    10    5    0

Fig. 4

Fig. 5